(19) Europäisches Patentamt
European Patent Office
Office européen des brevets

(11) Publication number: 0 506 359 A2

(12) EUROPEAN PATENT APPLICATION

(21) Application number: 92302563.9

(22) Date of filing: 25.03.92

(51) Int. Cl.5: C08L 63/00, C08L 61/00, C08G 59/32, H01L 23/00

(30) Priority: 29.03.91 JP 91474/91

(43) Date of publication of application: 30.09.92 Bulletin 92/40

(84) Designated Contracting States: DE FR GB

(71) Applicant: SHIN-ETSU CHEMICAL CO., LTD.
6-1, Ohtemachi 2-chome
Chiyoda-ku Tokyo(JP)

(72) Inventor: Shiobara, Toshio
No. 10-13, Isobe 3-chome
Annaka-shi, Gunma-ken(JP)
Inventor: Futatsumori, Koji
No. 571, Otake
Annaka-shi, Gunma-ken(JP)

(74) Representative: Stoner, Gerard Patrick et al
Mewburn Ellis 2 Cursitor Street
London EC4A 1BO(GB)

(54) **Epoxy resin compositions and semiconductor devices encapsulated therewith.**

(57) An epoxy resin composition comprising
(A) at least one epoxy resin selected from naphthalene ring-containing epoxy resins of the following structural formulae (1) and (2):

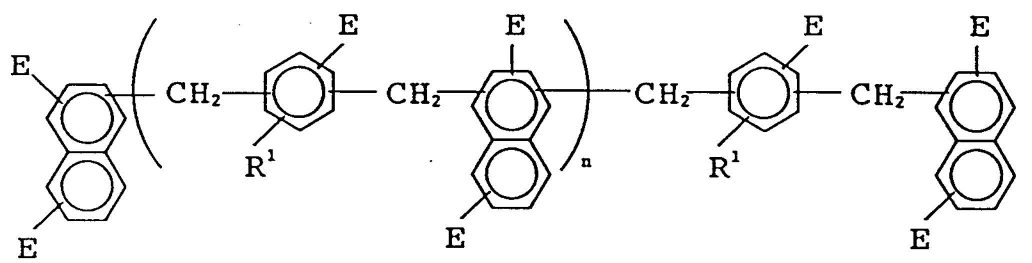

....(1)

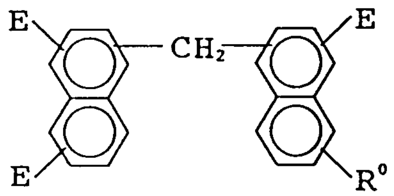

....(2)

wherein E is



Rank Xerox (UK) Business Services

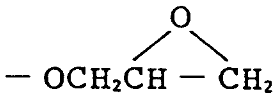 ,

$R^0$ is a hydrogen atom or

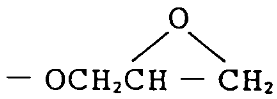 ,

$R^1$ is a hydrogen atom or a monovalent hydrocarbon group having 1 to 6 carbon atoms, and
n is an integer of from 0 to 5,
(B) a phenolic resin, and
(C) an inorganic filler.

The compositions have good flow and cure to products having low modulus of elasticity, a low coefficient of expansion, high Tg irrespective of low stresses, and low water adsorption. Semiconductor devices encapsulated with the present composition are highly reliable even after being subject to thermal shocks upon surface mounting.

This invention relates to epoxy resin compositions and to their manufacture and use, particularly for encapsulating semiconductor devices. In this field, desiderata include improved flow, cure into products having a low coefficient of expansion, a high glass transition temperature, low stress, good adhesion, and low moisture adsorption.

## BACKGROUND

The mainstream of the modern semiconductor industry involves resin encapsulated diodes, transistors, IC, LSI, and super LSI. Among various resin compounds for encapsulating semiconductor devices, epoxy resin compositions comprising curable epoxy resins blended with curing agents and various additives are most widely used because they are generally good in moldability, adhesion, electrical properties, mechanical properties and moisture resistance compared with other thermosetting resins. The present day trend for these semiconductor devices is toward an increasingly high degree of integration and correspondingly increased chip size. Packages, on the other hand, are desired to be smaller and thinner in outer dimensions to meet the demands of compactness and light weight for electronic equipment. Further, as to the attachment of semiconductor parts on circuit boards, surface mounting of semiconductor parts is now often employed for reasons of increased part density on boards and reduced board thickness.

A common approach to the surface mounting of semiconductor parts is to dip entire semiconductor devices in a solder bath or to pass them through a hot zone of molten solder. Thermal shocks associated with this process cause encapsulating resin layers to crack or incur separation at the interface between the lead frames or chips and the encapsulating resin. Such cracks and separation become more serious if the semiconductor device encapsulating resin layers have absorbed moisture prior to thermal shocks encountered during surface mounting. Since encapsulating resin layers, however, inevitably absorb moisture in practical manufacturing steps, epoxy resin-encapsulated semiconductor devices after mounting tend to suffer from reliability problems.

The general problem addressed herein is to provide new epoxy resin compositions, also modes of preparation and use thereof. It would be preferred to provide a new and improved epoxy resin composition exhibiting improved flow behavior and curing into products featuring a low coefficient of expansion, low stresses, a high glass transition temperature (Tg), and low moisture absorption.

Another preferred aspect would be to enable semiconductor device encapsulated with a cured product of the epoxy resin composition, which has good reliability after thermal shocks e.g. during surface mounting.

By blending (A) certain naphthalene ring-containing epoxy resins, (B) phenolic resin, and (C) an inorganic filler, the inventors have been able to obtain compositions having excellent flow and which cure into products having a low coefficient of expansion, a high glass transition temperature (Tg), and low stresses as characterized by a lowering of modulus of elasticity in a temperature range above Tg. In contrast to prior art conventional epoxy resin compositions which were obtained by a method designed so as to provide low modulus of elasticity, but accompanied by such drawbacks as a lowering of Tg and a loss of strength, they were able to obtain epoxy resin compositions yielding cured products having good properties which were not found in the conventional epoxy resin compositions, that is, cured products which are free of a lowering of Tg irrespective of low modulus of elasticity and absorb little moisture. The compositions are moldable over semiconductor devices. In addition, semiconductor devices encapsulated with cured products of the presently formulated epoxy resin composition remained highly reliable after thermal shocks during surface mounting. Therefore, the present compositions may be applicable to the encapsulation of semiconductor devices of all types including SOP, SOJ, TSOP and TQFP types since it has good properties as an encapsulant for surface mounting semiconductor devices.

Based on the above, one aspect of the invention provides an epoxy resin composition comprising (A) an epoxy resin, (B) a phenolic resin, and (C) an inorganic filler. The epoxy resin (A) is selected from naphthalene ring-containing epoxy resins of the following structural formulae (1) and (2):

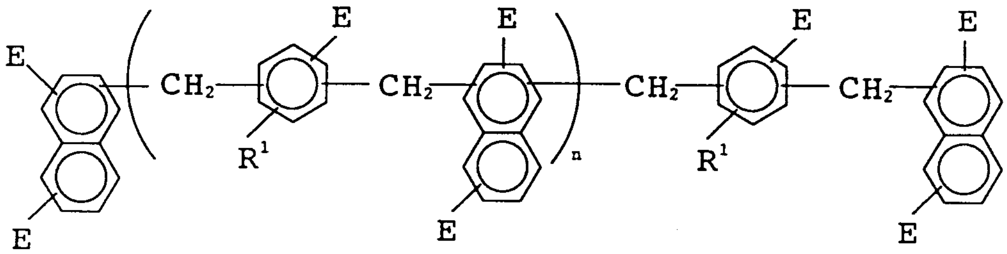

....(1)

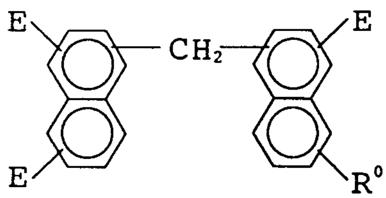

....(2)

wherein E is

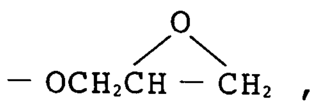

$R^0$ is a hydrogen atom or

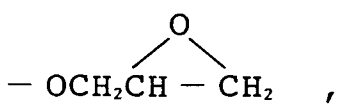

$R^1$ is a hydrogen atom or a monovalent hydrocarbon group having 1 to 6 carbon atoms, and
n is an integer of from 0 to 5.

Other aspects are methods of preparing the compositions, and their use as an encapsulant particularly for semiconductor devices.

## DETAILED DESCRIPTION

As mentioned above, the epoxy resin composition of the present invention comprises (A) an epoxy resin, (B) a phenolic resin, and (C) an inorganic filler.

Component (A) is at least one epoxy resin selected from naphthalene ring-containing epoxy resins of the following structural formulae (1) and (2).

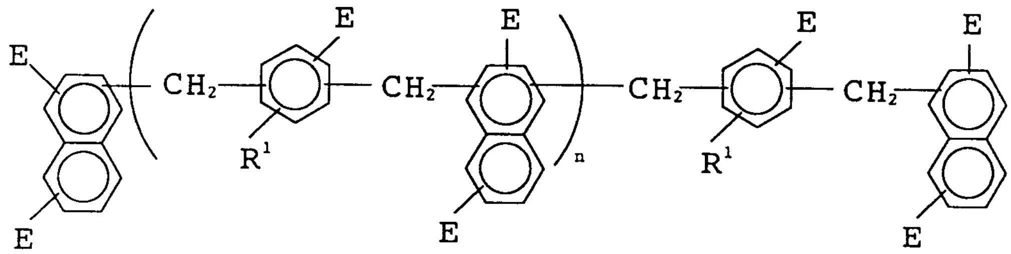

....(1)

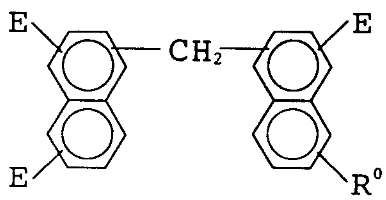

....(2)

In the formulae, E is

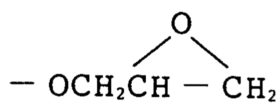

,

$R^0$ is a hydrogen atom or

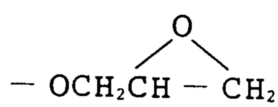

,

$R^1$ is a hydrogen atom or a monovalent hydrocarbon group having 1 to 6 carbon atoms, e.g. alkyl such as methyl, ethyl, propyl, isopropyl, butyl, and t-butyl groups, and

n is an integer of from 0 to 5.

Illustrative, non-limiting examples of the naphthalene ring-containing epoxy resin are given below.

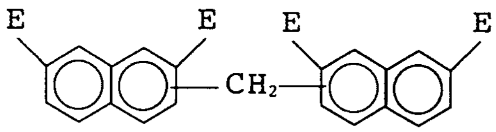

....(3)

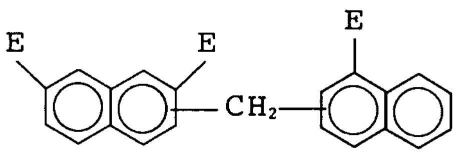

....(4)

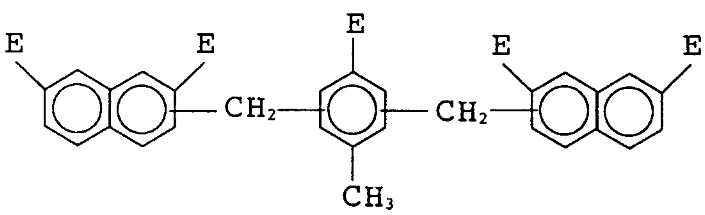

....(5)

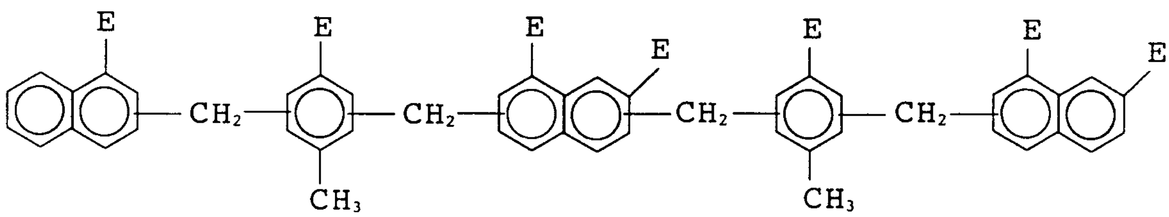

....(6)

In the formulae, E is as defined above.

Among these examples, naphthalene ring-containing epoxy resins having a relatively low degree of polymerization as represented by formulae (3), (4) and (5) are preferred for allowing the composition to remain flowing. Better flow behavior is available when component (A) contains at least 60% by weight based on the total epoxy resins of a naphthalene ring-containing epoxy resin of formula (5) which corresponds to formula (1) wherein n = 0 or a naphthalene ring-containing epoxy resin of formula (3) or (4) which corresponds to formula (2).

Together with the above-mentioned epoxy resins having a naphthalene ring, there may be used conventional epoxy resins, if desired. Typical of such additional epoxy resins are those having at least two epoxy groups in a molecule, for example, bisphenol-A type epoxy resins, phenol novolak type epoxy resins, glycidyl ether type epoxy resins such as allyl phenol novolak type epoxy resins, triphenol alkane type epoxy resins and polymers thereof, biphenyl type epoxy resins, dicyclopentadiene type epoxy resins, phenol aralkyl type epoxy resins, glycidyl ester type epoxy resins, cycloaliphatic epoxy reins, heterocyclic epoxy resins, and halogenated epoxy resins. Other naphthalene ring-containing epoxy resins which are useful as additional epoxy resins are given below.

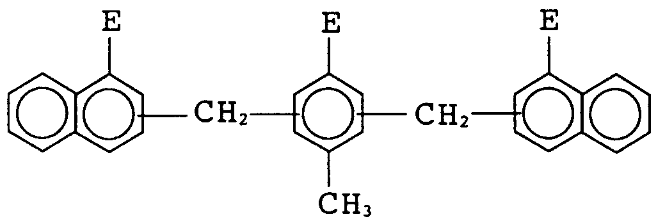

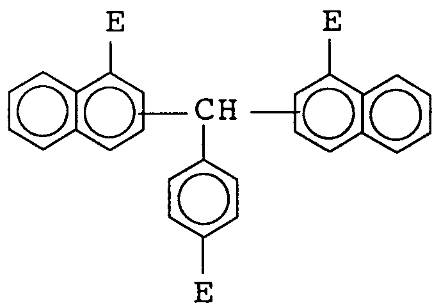

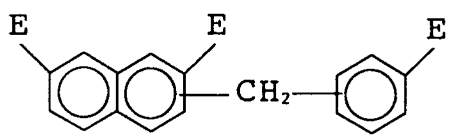

In the formulae, E is as defined above.

Component (B) is a phenolic resin which is a curing agent for epoxy resin (A). Included are novolak type phenolic resins, resol type phenolic resins, triphenol alkane type resins and polymers thereof. It is possible to use amine curing agents and acid anhydride curing agents in combination with the phenolic resin curing agent. Another useful phenolic resin as component (B) is a phenolic resin of the following general formula (7):

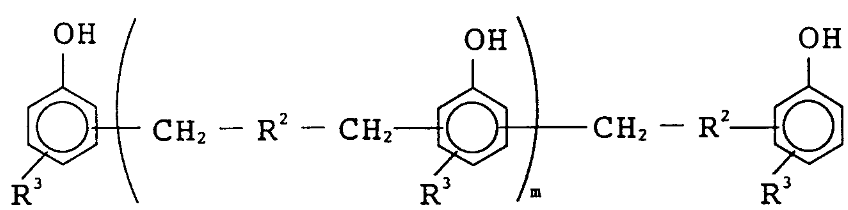

....(7)

wherein $R^2$ is selected from the group consisting of

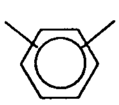 , 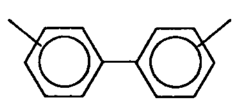 , 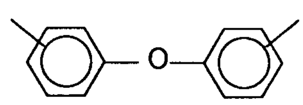

and substituted ones thereof in which some or all of the hydrogen atoms are replaced by alkyl groups having 1 to 5 carbon atoms, $R^3$ is a hydrogen atom or an alkyl group having 1 to 4 carbon atoms, and letter m is an integer of from 0 to 5.

Illustrative, non-limiting examples of the phenolic resin of formula (7) are given below.

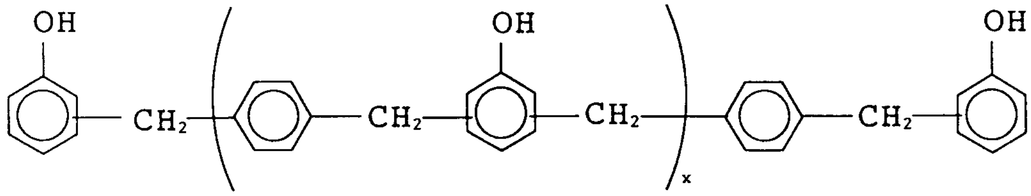

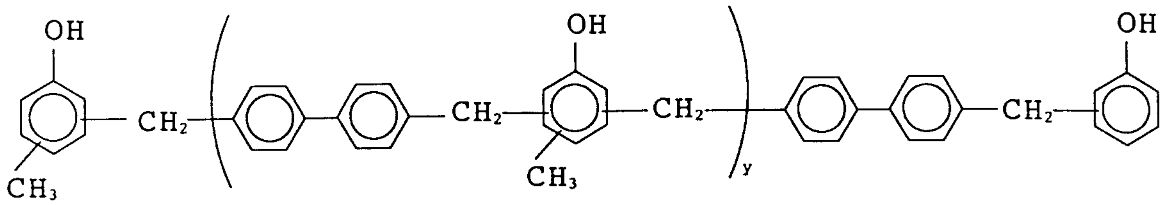

In the formulae, x and y each are an integer of from 1 to 5.

Phenolic resins of formula (7) are effective for improving crack resistance upon solder dipping after moisture absorption and reducing moisture absorption, but can sometimes lead to a lowering of Tg when used as a sole curing agent. Thus, rather than using the phenolic resin of formula (7) singly, it is desirable to use the phenolic resin of formula (7) in combination with other phenolic resins, for example, phenol novolak resins, cresol novolak resins, triphenol alkane type resins, and naphthalene ring-containing phenolic resins which are shown below.

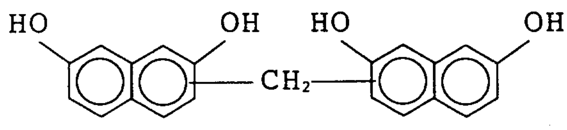

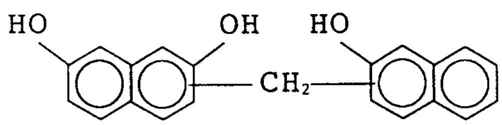

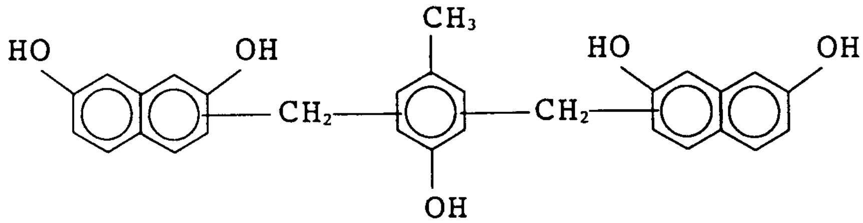

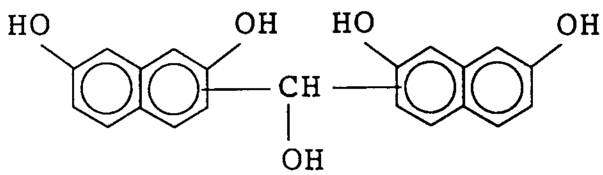

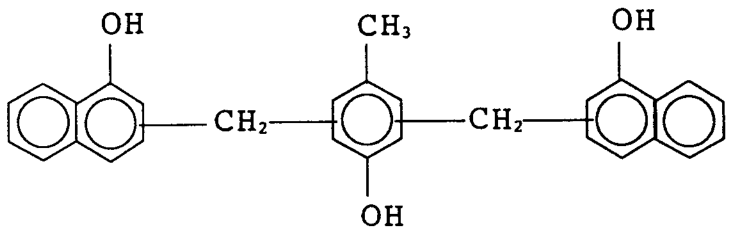

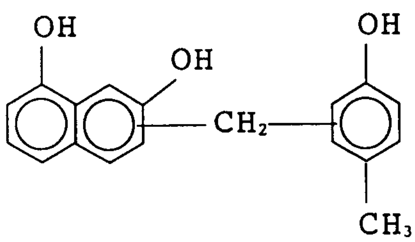

Blends of the phenolic resin of formula (7) with these naphthalene ring-containing phenolic resin are best suited for minimizing moisture absorption without lowering Tg. The phenolic resin of formula (7) is preferably contained in an amount of at least 10%, more preferably about 30 to 80% by weight of the total phenolic resins as component (B).

Preferably, the content of naphthalene ring in both the epoxy resin as component (A) and the phenolic resin as curing agent (B) ranges from about 5% to about 80%, especially from about 10% to about 60% by weight based on the total weight of these components. With a naphthalene ring content of less than 10% by weight, cured products would be less reduced in moisture absorption and modulus of elasticity in a temperature range above Tg and consequently, less improved in crack resistance upon thermal shocks after moisture absorption. Resins having a naphthalene ring content of more than 80% by weight may sometimes lead to a melt viscosity too high for dispersal of the resin during preparation, resulting in some disadvantages of molding and cured product properties.

Desirably, components (A) and (B) contain epoxy and phenolic hydroxyl groups in such quantities that the ratio of the quantity of epoxy group (a mol) to the quantity of phenolic hydroxyl group (b mol), a/b ranges from 1/2 to 3/2. Outside the range, curing property, low stress, and moisture absorption tend to be less good.

Component (C) is an inorganic filler which may be selected from those commonly used for epoxy resins. Examples include silicas such as fused silica and crystalline silica, alumina, silicon nitride, aluminum nitride, boron nitride, titanium oxide, and glass fibers. Among these, fused silica is preferred, and fused silica having a mean grain size of about 3 to 15 $\mu$m is especially preferred from a molding aspect. The fused silica is desirably of spherical shape for high loadings and less stresses relative to the chip surface. The inorganic filler is preferably surface treated with silane coupling agents prior to blending in order to enhance the interfacial strength between the resin and the filler.

These inorganic fillers may be used alone or in admixture of two or more. The filler is preferably used in an amount of about 100 to 1,000 parts, especially about 200 to 700 parts by weight per 100 parts by weight of the total of components (A) and (B) although the filler content is not particularly limited.

A curing catalyst may be blended in the epoxy resin composition of the invention. Suitable curing catalysts used herein include imidazoles, tertiary amines, and phosphorus compounds. The preferred curing catalysts are mixtures of 1,8-diazabicyclo(5.4.0)undecene-7 and triphenylphosphine in a weight ratio of from 0:1 to 1:1, especially from 0.01:1 to 0.5:1. A higher proportion of 1,8-diazabicyclo(5.4.0)undecene-7 beyond this range would sometimes lead to a lower glass transition temperature. The amount of the curing catalyst added is not particularly limited although it is preferably added in an amount of 0.2 to 2 parts, more preferably 0.4 to 1.2 parts by weight per 100 parts by weight of the total of components (A) and (B).

The composition may further contain various additives if desired. Exemplary well-known additives include stress lowering agents such as thermoplastic resins, thermoplastic elastomers, organic synthetic rubbers, and silicones; mold release agents such as waxes (e.g., carnauba wax) and fatty acids (e.g., stearic acid) and metal salts thereof; pigments such as carbon black, cobalt blue, and red iron oxide; flame retardants such as antimony oxide and halides; surface treating agents such as silanes (e.g., γ-glycidoxypropyltrimethoxysilane) and alkyl titanates; antioxidants; halogen trapping agents; other additives, and mixtures thereof.

The epoxy resin compositions may be prepared e.g. by mixing and agitating predetermined amounts of the necessary components uniformly, and milling the mixture in milling means preheated at 70 to 95 °C, for example, a kneader, roll mill and extruder, followed by cooling and comminution. The order of mixing the components is not critical.

The compositions of the invention are advantageously applicable in encapsulating various types of semiconductor device including SOP, SOJ, TSOP, and TQFP types. The compositions can be molded by conventional methods including transfer molding, injection molding, and casting. Most often, the epoxy resin compositions are molded at a temperature of about 150 to about 180 °C for about 30 to about 180 seconds and post cured at a temperature of about 150 to 180 °C for about 2 to about 16 hours.

## EXAMPLE

Examples of the present invention are given below together with comparative examples, by way of illustration and not by way of limitation. All parts are by weight.

### Examples 1-7 and Comparative Example 1

Epoxy resin compositions were prepared by uniformly melt mixing the following components in a hot two-roll mill, cooling and comminuting the mixtures. The components used were an epoxy resin and a phenolic resin both shown below and used in the amounts shown in Table 1, 0.6 parts of a curing catalyst shown below, 0.5 parts of triphenylphosphine, 10 parts of brominated epoxy resin (BREN-S, manufactured by Nihon Kayaku K.K.), 250 parts of spherical fused silica having a mean grain size of 10 µm and a specific surface area of 2.5 $m^2/g$, 250 parts of spherical fused silica having a mean grain size of 6.5 µm and a specific surface area of 3.1 $m^2/g$, 8 parts of antimony trioxide, 1.5 parts of carbon black, 1 part of carnauba wax, and 3 parts of γ-glycidoxypropyltrimethoxysilane.

| Epoxy resin | Epoxy equiv. | Softening point (℃) |
|---|---|---|
| (I) 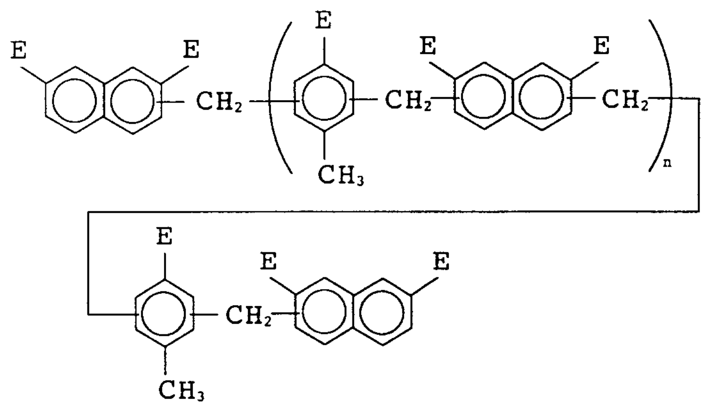 (The resin having n = 0 is 85% of the overall weight.) | 195 | 96 |
| (II) 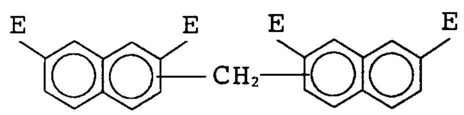 EXA 4700 (Dai－Nihon Ink K.K.) | 164 | 90 |
| (III) 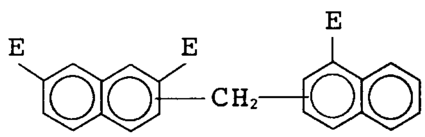 EXA 4750 (Dai－Nihon Ink K.K.) | 190 | 77 |
| (IV) 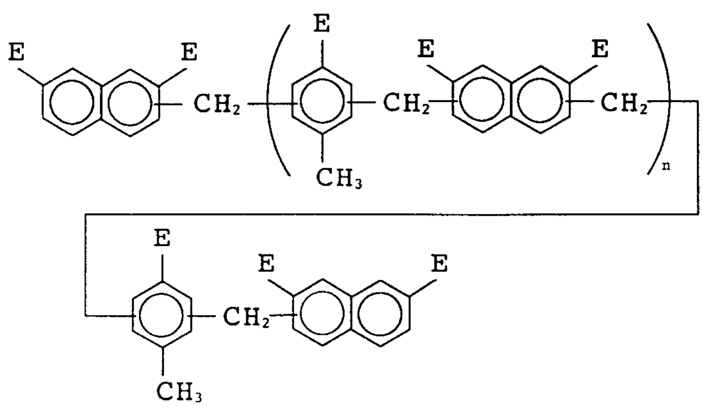 (The resin having n = 0 is 45% of the overall weight.) | 195 | 105 |

| | | | |
|---|---|---|---|
| ( V ) | Ortho－cresol novolak type epoxy resin EOCN－1020－65 (Nihon Kayaku K.K.) | 210 | 65 |

<u>Phenolic resin</u>

| | | OH equiv. | Softening point(℃) |
|---|---|---|---|
| ( I ) | 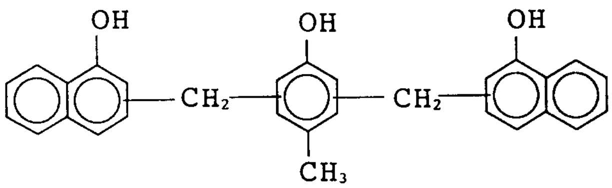 | 140 | 113 |
| ( II ) | 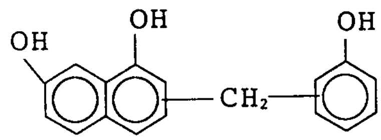 | 90 | 98 |
| ( III ) | 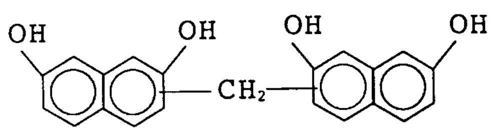 | 87 | 115 |
| ( IV ) | 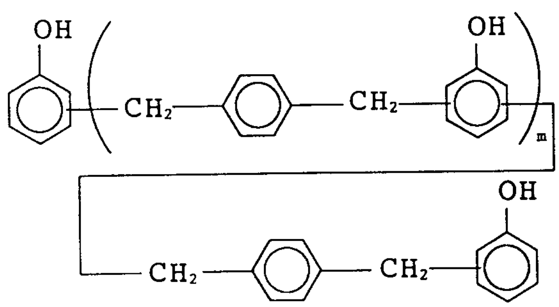 Milex (Mitsui－Toatsu K.K.) | 173 | 70 |
| ( V ) | Phenol novolak resin TD2131 (Dai－Nihon Ink K.K.) | 110 | 90 |

<u>Curing catalyst</u>

This was prepared by mixing 1,8－diaza－bicyclo(5.4.0)undecene－7 and phenol novolak resin TD2131 (manufactured by Dai-Nihon Ink K.K.) in a weight ratio of 20/80, heat melting them at 130 ° C for 30 minutes, and atomizing to a size of less than 50 µm.

For these compositions, the following tests (A) to (F) were carried out. The results are shown in Table 1.

(A) spiral flow

Using a mold according to the EMMI standard, measurement was made at 180 ° C and 70 kg/cm$^2$.

(B) Flexural strength and Flexural modulus

Test bars of 10 x 4 x 100mm, which were molded at 180°C and 70kg/cm$^2$ for 2 minutes and post cured at 180°C for 4 hours, were tested at 125°C according to JIS K6911.

(C) Coefficient of linear expansion ($\mu$) and Glass transition temperature (Tg)

Test pieces of 4 mm in diameter and 15 mm long were examined in accordance with the TMA method by heating the test pieces at a rate of 5 °C/min.

(D) Crack resistance upon soldering after moisture absorption

Silicon chips of 2 × 4 × 0.4 mm were bonded to SO package lead frames (42 alloy) of 4 × 12 × 1.8 mm and then encapsulated with the epoxy resin compositions by molding at 180°C and 70 kg/cm$^2$ for 2 minutes and post curing at 180°C for 4 hours. The packages were allowed to stand in a hot humid atmosphere at 85°C and RH 85% for 48 and 168 hours and then immersed for 10 seconds in a solder bath at 250°C. Then the packages were disintegrated to observe the occurrence of internal cracks. Reported is the number of cracked packages/the total number of packages tested.

(E) Moisture resistance

4-M DRAM chips were bonded to SOJ frames with 20 pins and then encapsulated with the epoxy resin compositions by molding at 180°C and 70 kg/cm$^2$ for 2 minutes and post curing at 180°C for 4 hours. The packages were allowed to stand for 24 hours in a hot humid atmosphere at 121°C and RH 100%, then dipped for 10 seconds in a solder bath at 260°C, and again allowed to stand for 300 hours in a hot humid atmosphere at 121 °C and RH 100%. Reported is the number of Al wire broken packages/the total number of packages tested.

(F) Water absorption

Disks of 50 mm in diameter and 2 mm thick were molded at 180°C and 70 kg/cm$^2$ for 2 minutes and post cured at 180°C for 4 hours. The disks were subjected to a pressure cooker test (PCT) at 121°C/100% RH for 24 hours before the water absorption (percent) was measured.

Table 1

| | | E1 | E2 | E3 | E4 | E5 | E6 | E7 | CE1 |
|---|---|---|---|---|---|---|---|---|---|
| Epoxy resin ( I ) | | 56.1 | 60.4 | — | — | — | 23.2 | 13.7 | — |
| Epoxy resin ( II ) | | — | — | 51.5 | — | 48.0 | 23.2 | — | — |
| Epoxy resin ( III ) | | — | — | — | 47.7 | — | — | 40.9 | — |
| Epoxy resin ( IV ) | | — | — | — | — | 41.1 | — | — | — |
| Epoxy resin ( V ) | | — | — | — | — | — | — | — | 57.5 |
| Phenolic resin ( I ) | | — | — | — | 21.1 | — | 21.8 | — | — |
| Phenolic resin ( II ) | | — | 29.6 | — | — | — | — | — | — |
| Phenolic resin ( III ) | | — | — | 19.3 | — | — | — | — | — |
| Phenolic resin ( IV ) | | — | — | 19.3 | 21.1 | 21.0 | 21.8 | 17.1 | — |
| Phenolic resin ( V ) | | 33.9 | — | — | — | 21.0 | — | — | 32.5 |
| Spiral flow, inch | | 62 | 60 | 68 | 78 | 73 | 70 | 74 | 89 |
| Flexural strength, $kg/mm^2$ | | 1.8 | 1.9 | 1.7 | 1.6 | 1.6 | 1.7 | 1.7 | 1.7 |
| Flexural modulus, $kg/mm^2$ | | 110 | 82 | 75 | 65 | 80 | 83 | 73 | 125 |
| Tg, ℃ | | 173 | 170 | 165 | 168 | 167 | 172 | 165 | 159 |
| $\mu$, $10^{-5}$/℃ | | 1.5 | 1.4 | 1.4 | 1.4 | 1.4 | 1.4 | 1.4 | 1.5 |
| Crack resistance | 85℃/85% RH 48 hr. | 0/20 | 0/20 | 0/20 | 0/20 | 0/20 | 0/20 | 0/20 | 10/20 |
| | 85℃/85% RH 168 hr. | 0/20 | 0/20 | 0/20 | 0/20 | 0/20 | 0/20 | 0/20 | 20/20 |
| Moisture resistance | | 0/20 | 0/20 | 0/20 | 0/20 | 0/20 | 0/20 | 0/20 | 6/20 |
| Water absorption, % | | 0.32 | 0.30 | 0.28 | 0.29 | 0.30 | 0.28 | 0.29 | 0.43 |

As seen from Table 1, the epoxy resin compositions embodying the invention exhibited good flow behaviour and cured to products having a low modulus of elasticity, especially at temperatures above Tg, a low coefficient of linear expansion, high Tg, and low moisture absorption. The semiconductor devices encapsulated with the present compositions had improved crack resistance upon soldering after moisture absorption and moisture resistance and remained highly reliable even after being subject to thermal shocks

upon surface mounting.

There have been described epoxy resin compositions comprising components (A), (B), and (C) as defined above which are free flowing and cure to products having low modulus of elasticity, especially at temperatures above Tg, a low coefficient of expansion, high Tg irrespective of low stresses, and low water absorption. Then the semiconductor devices encapsulated with the present compositions remain highly reliable even after being subject to thermal shocks upon surface mounting.

Although some preferred embodiments have been described, many modifications and variations may be made thereto in the light of the above teachings. It is therefore to be understood that within the scope of the appended claims, the invention may be practiced otherwise than as specifically described.

## Claims

**1.** An epoxy resin composition comprising

(A) at least one epoxy resin selected from naphthalene ring-containing epoxy resins of the following structural formulae (1) and (2):

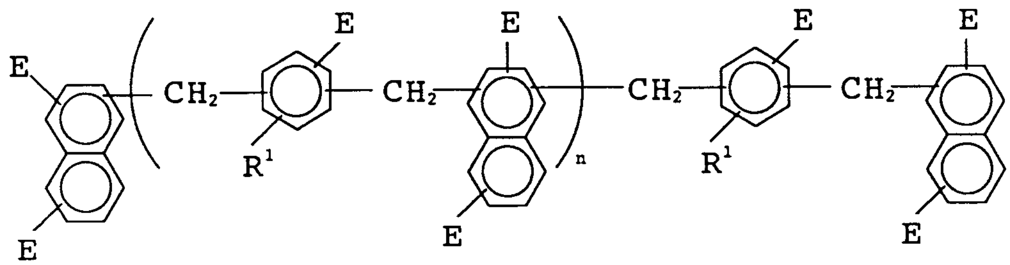

....(1)

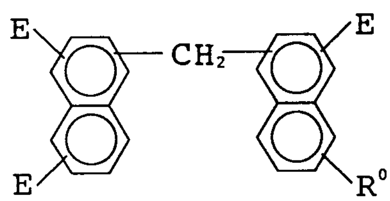

....(2)

wherein E is

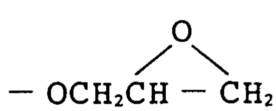 ,

$R^0$ is a hydrogen atom or

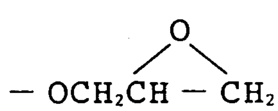 ,

$R^1$ is a hydrogen atom or a monovalent hydrocarbon group having 1 to 6 carbon atoms, and
n is an integer of from 0 to 5,

(B) a phenolic resin, and

(C) an inorganic filler.

**2.** An epoxy resin composition of claim 1 wherein component (A) contains at least 60% by weight of at

least one epoxy resin selected from naphthalene ring-containing epoxy resins of formulae (3) to (6):

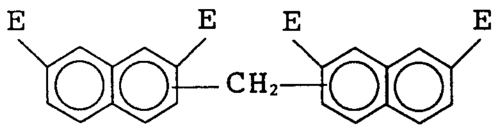

....(3)

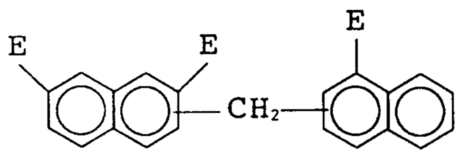

....(4)

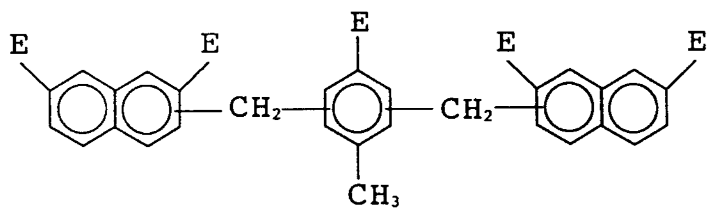

....(5)

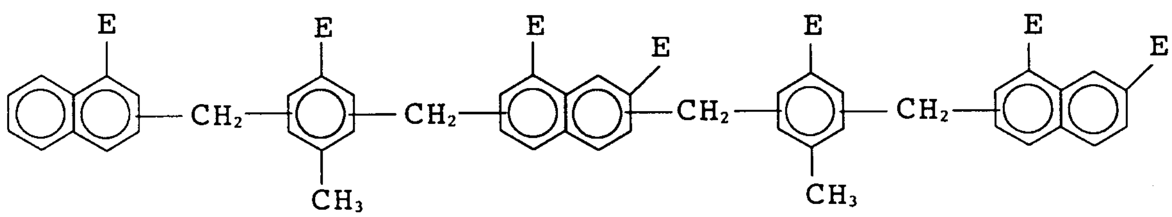

....(6)

wherein E is as defined above.

3. An epoxy resin composition of claim 1 or 2 wherein components (A) and (B) contain about 5 to 80% by weight of naphthalene ring.

4. A composition of any one of claims 1 to 3 wherein components (A) and (B) contain epoxy and phenolic hydroxyl groups in such quantities that the molar ratio of epoxy group to phenolic hydroxyl group ranges from 1/2 to 3/2.

5. A composition of any one of the preceding claims wherein 100 to 1,000 parts by weight of filler (C) is present per 100 parts by weight of components (A) and (B) combined.

6. A semiconductor device encapsulated with an epoxy resin composition of any one of claims 1 to 5 in cured state.

7. A method comprising the preparation of an epoxy resin composition according to any one of claims 1 to 5, by mixture of the constituents (A), (B) and (C) thereof.

8. Use of a composition according to any one of claims 1 to 5 as an encapsulant.